# EUROPÄISCHE PATENTSCHRIFT

(11) **EP 0 389 941 B1**
(45) Veröffentlichungstag und Bekanntmachung des Hinweises auf die Patenterteilung: **07.12.1994**
(21) Anmeldenummer: 90105296.9
(22) Anmeldetag: 21.03.1990
(51) Int. Cl.: C04B 35/00, C04B 35/64, H01L 39/24

(54) **Verfahren zur Herstellung eines länglichen Körpers bestehend aus längsgerichteten nadelförmigen Kristallen aus einem supraleitenden keramischen Stoff**
Process for the production of an elongated body consisting of axially aligned needle-like crystals of a superconducting ceramic material
Procédé de fabrication d'un corps céramique allongé supraconducteur à base de cristaux aciculaires allignés dans le sens de la longueur

(30) Priorität: 31.03.1989 CH 1184/89
(43) Veröffentlichungstag der Anmeldung: 03.10.1990
(73) Patentinhaber: ASEA BROWN BOVERI AG, 5400 Baden (CH)
(72) Erfinder: Meyer, Gundolf, Dr., CH-5413 Birmenstorf (CH)

(56) Entgegenhaltungen:
- EP-A- 0 282 286
- EP-A- 0 298 647
- APPL. PHYS. LETT., Band 52, Nr. 21, 23. Mai 1988, Seiten 1831-1833, American Institute of Physics; G.S. GRADER et al.: "Improved press forging of Ba2YCu3Ox superconductor"
- JAPANESE JOURNAL OF APPLIED PHYSICS, Band 27, Nr. 7, Juli 1988, Seiten L1209-L1212; T. TAKENAKA et al.: "Superconducting properties of grain-oriented YBa2Cu307-x ceramics"
- J. AM. CERAM. SOC., Band 70, Nr. 12, 1987, Seiten C-388 - C-390; I.-W. CHEN et al.: "Texture development in YBa2Cu3Ox by hot extrusion and hot-pressing"

## Beschreibung

### Technisches Gebiet

Technologie der elektrischen Supraleiter. In neuester Zeit nimmt die Bedeutung von Werkstoffen, welche supraleitende Eigenschaften haben, mehr und mehr zu. Die Entdeckung von neuen supraleitenden Werkstoffen, insbesondere des Typs Seltene Erden/Ba/Cu/O, führte zu einer beträchtlichen Erweiterung der Anwendungsmöglichkeiten für Supraleiter, da diese Stoffe bereits bei Temperaturen oberhalb 50K supraleitend werden.

Die Erfindung bezieht sich auf die Bereitstellung von geeigneten Vormaterialien für die Weiterentwicklung und Verbesserung von Bauteilen aus einem keramischen Hochtemperatur-Supraleiter in Drahtform, wobei den Bedürfnissen der industriellen Grossproduktion Rechnung getragen werden soll.

Insbesondere betrifft sie ein Verfahren zur Herstellung eines länglichen Körpers bestehend aus längsgerichteten, nadelförmigen Kristallen aus einem keramischen Hochtemperatur-Supraleiter auf der Basis von SEBa₂Cu₃O_{6,5+y}, wobei SE ein seltenes Erdmetall bedeutet und 0<y<1 ist, bei welchem Verfahren
(a) ein homogenes, nicht-supraleitendes Vormaterial in Pulverform hergestellt wird, welches die Elemente RE, Ba und Cu in einem stöchiometrischen Verhältnis von RE:Ba:Cu = 1:2:3 enthält;
(b) aus dem Vormaterial der längliche Körper geformt wird; und
(c) der längliche Körper unter hohem Druck und hohen Temperaturen gesintert wird.

### Stand der Technik

Es hat sich gezeigt, dass keramische Hochtemperatur-Supraleiter der Klasse SEBa₂Cu₃O_{6,5+y} (SE = seltenes Erdmetall, O<y<1) in jeder Hinsicht stark anisotrope Eigenschaften haben. Dies hängt mit der Kristallstruktur (Perowskit-Gitter) zusammen und gilt insbesondere für die kritische Stromdichte j_{c} (Stromtragfähigkeit). Die Korngrenzen in polykristallinen Kermiken begrenzen die kritischen Stromdichten auf kleine Werte, so dass diese Werkstoffe für die meisten technischen Anwendungen bei der Siedetemperatur von flüssigem Stickstoff (T = 77 K) nicht geeignet sind. Für gesinterte Proben aus polykristallinem YBa₂Cu₃O_{≈7} wurden bisher in Magnetfeldern > lT kritische stromdichten j_{c} bis maximal 100 A/cm² gemessen. Anwendungen z.B. in Magnetspulen erfordern jedoch Stromdichten, die etwa um einen Faktor 1000 höher liegen.

Aus dem Obenstehenden geht hervor, dass ein orientiertes Kristallitgefüge gegenüber wirr und statistisch beliebig angeordneten Kristalliten wesentlich höhere kritische Stromdichten erwarten lässt. Die höchsten Stromdichten j_{c} von mehr als 10⁵ A/cm² wurden in epitaktisch auf SrTiO₃-Einkristallen aufgewachsenen dünnen Supraleiterschichten beobachtet. Dieses Verfahren bedingt jedoch teure Einkristalle als Substrate und lässt sich auf die Herstellung von Drähten (Mehrfachfilamente) und Bändern grosser Länge nicht anwenden.

Es ist bekannt, dass Partikel der Verbindung YBa₂Cu₃O_{≈7} eine nadelförmige oder plattenförmige Teilchenmorphologie haben können, die von Wachstumsanisotropien herrühren. Die kurze Achse dieser Teilchen entspricht dabei kristallographisch der c-Achse des Gitters. Die langen Achsen der Teilchen geben die a- bzw. b-Achse des Gitters wieder, wobei diese Richtungen deutlich höhere kritische Ströme aufnehmen können als die c-Achse.

Aus der Literatur ist ein Effekt bekannt, der als sekundäre Rekristallisation bezeichnet wird. Bei der sekundären Rekristallisation tritt Kornwachstum in einem Gefüge nur bei einer sehr kleinen Zahl von Körnern auf, die als Keime wirken. Die übrigen Körner im Gefüge verändern sich kaum, bis sie vollständig durch das Wachstum der Keime aufgebraucht sind. Die Keime können zu Körnern von bis zu 1 mm wachsen. Falls die Keime vor Beginn des Kornwachstums eine Vorzugsorientierung haben, dass entsteht durch sekundäre Rekristallisation ein Gefüge mit einer entsprechenden Textur.

Zum Stand der Technik werden die nachfolgenden Literaturstellen zitiert:
- Quentin Robinson, P. Georgopoulos, D. Lynn Johnson, Henry O. Marcy, Carl R. Kannewurf, S.-J. Hwu, Tobin J. Marks, K.R. Poeppelmeier, S.N. Song, J.B. Ketterson, "Sinter-Forged YBa₂Cu₃O_{7-δ}, Materials Research Center, Northwestern University Evanston, IL 60201, Advanced Ceramic Materials, Vol. 2, NO. 3B, Special Issue, June 1987
- R.W. McCallum, J.D. Verhoeven, M.A. Noack, E.D. Gibson, F.C. Laabs and D.K. Finnemore, "Problems in the Production of YBa₂Cu₃Oₓ Superconducting Wire", Ames Laboratory, Usdoe, Iowa State, University, Ames, IA 50011, Advanced Ceramic Materials, Vol. 2, NO. 3B, Special Issue, June 1987
- G.S. Grader, H.M. O'Bryan and W.W. Rhodes, "Improved press forging of Ba₂YCu₃Oₓ superconductor", 1988 American Institute of Physics, Appl. Phys. Lett. 52(21), 23 May 1988, p. 1831-1833.
- T. Takenaka et al., Jap.J.Appl.Phys. 27 (1988), L1209-L1212, "Supersonducting Properties of Grain-Oriented YBa₂Cu₃O₇₋ₓ Ceramics"

### Darstellung der Erfindung

Der Erfindung liegt die Aufgabe zugrunde, ein Verfahren zur Herstellung eines länglichen Körpers bestehend aus längsgerichteten nadelförmigen Kristallen aus einem supraleitenden keramischen Stoff auf der Basis von SEBa₂Cu₃O_{6,5+y}, Wobei SE ein seltenes Erdmetall und O<y<1 bedeutet, anzugeben, indem, ausgehend von geeigneten Ausgangsmaterialien, ein Sinterprozess herangezogen wird. Die Kristalle sollen so orientiert sein, dass deren c-Achse senkrecht auf der Längsachse der nadelförmigen Teilchen steht und dass der gesamte Kristallverband mit den Längsachsen möglichst in der Längsachse des Werkstücks ausgerichtet ist. Das Verfahren soll sich für einen mit einem Stabilisierungswerkstoff (Ag) als Träger und Notstromleiter umgebenen Supraleiterverband eignen.

Diese Aufgabe wird dadurch gelöst, dass im eingangs erwähnten Verfahren das pulverförmige Vormaterial einen mittleren Partikeldurchmesser von 0.5 bis 5 µm aufweist, und die Sinterung unter einem Druck von 50 MPa (500 bar) bis 200 MPa (2000 bar) und bei einer Temperatur zwischen 600 °C und 850 °C für eine Zeit zwischen 5 und 20 h durchgeführt wird.

### Weg zur Ausführung der Erfindung

Die Erfindung wird anhand der nachfolgenden, durch Figuren erläuterten Ausführungsbeispiele beschrieben.

Dabei zeigt:
- Fig. 1: ein Fliessbild (Blockdiagramm) einer ersten Variante des Verfahrens zur Herstellung eines Körpers aus nadelförmigen Kristallen aus einem supraleitenden keramischen Stoff,
- Fig. 2: ein Fliessbild (Blockdiagramm) einer zweiten Variante des Verfahrens zur Herstellung eines Körpers aus nadelförmigen Kristallen aus einem supraleitenden keramischen Stoff,
- Fig. 3: eine schematische Darstellung der Ueberführung eines losen Pulvers aus supraleitender Substanz in einem Einzelkristall mittels Drucksintern,
- Fig. 4: einen schematischen Schnitt (vereinfachte metallographische Darstellung) durch einen länglichen Körper aus nadelförmigen orientierten Kristallen.

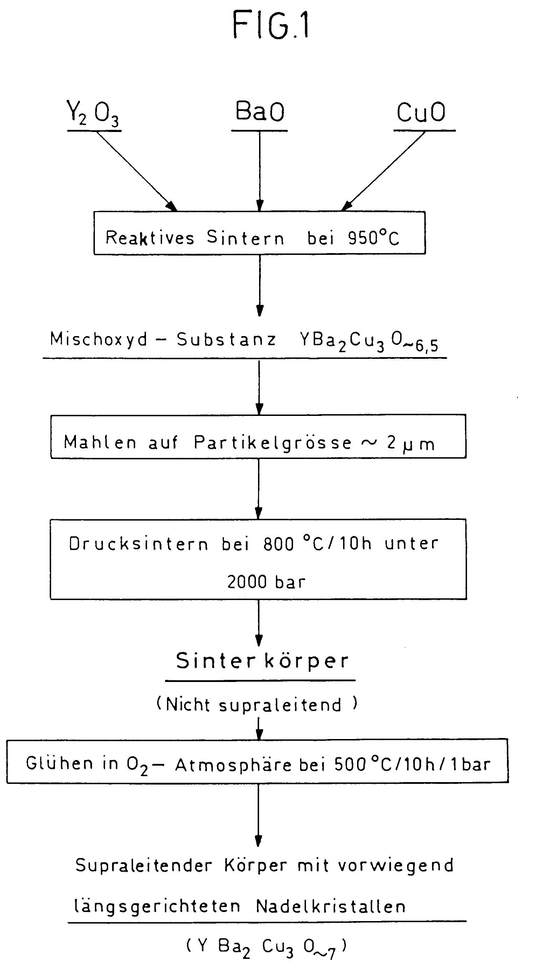

In Fig. 1 ist ein Fliessbild (Blockdiagramm) einer ersten Variante des Verfahrens zur Herstellung eines Körpers aus nadelförmigen Kristallen aus einem supraleitendenm keramischen Stoff dargestellt. Im vorliegenden Fall wird von feinkörnigen Pulvern der Oxyde Y₂O₃; BaO und CuO ausgegangen, die durch reaktives Sintern bei 950 °C und nachheriges langsames Abkühlen in ein Agglomerat der Mischoxyd-Substanz YBa₂Cu₃O_{≈6,5} übergeführt werden. Der durch Drucksintern hergestellte Sinterkörper hat zwar das richtige Y:Ba₂:Cu₃-Verhältnis, ist aber vorerst noch nicht supraleitend. Die Supraleitfähigkeit wird durch nochmalige Wärmebehandlung in O₂-Atmosphäre erzeugt. Das Diagramm bedarf keiner weiteren Erklärungen.

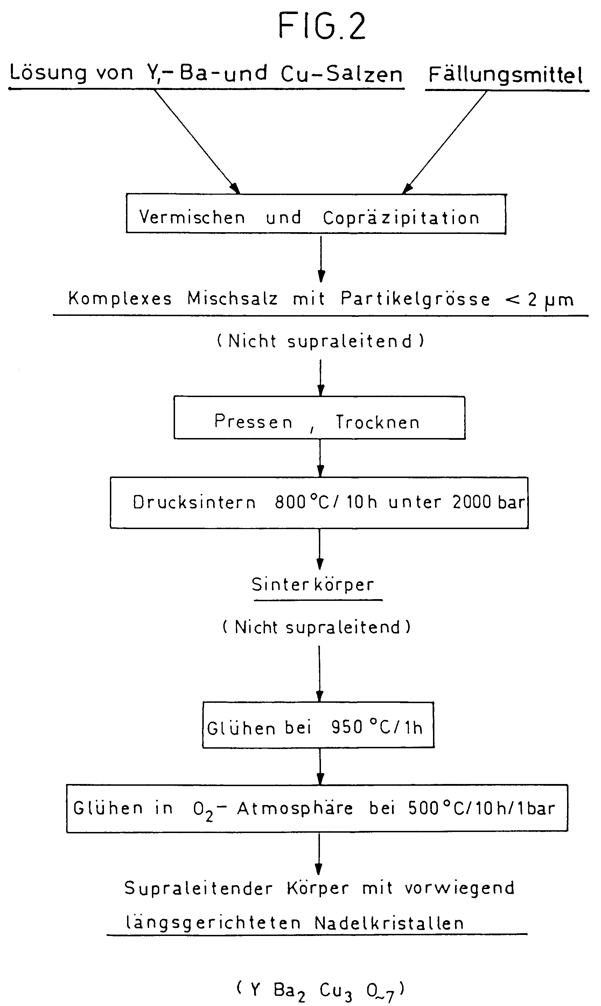

Fig. 2 bezieht sich auf ein Fliessbild (Blockdiagramm) einer zweiten Variante des Verfahrens zur Herstellung eines Körpers aus nadelförmigen Kristallen aus einem supraleitenden keramischen Stoff. In diesem Fall wird von Lösungen der Y-, Ba- und Cu-Salze ausgegangen, die durch ein Fällungsmittel nach dem Copräzipitationsverfahren in ein komplexes Mischsalz (meist Karbonat-Hydrat oder Oxalat) mit dem richtigen Y:Ba₂:Cu₃-Verhältnis übergeführt werden. Nach dem Pressen und Trocknen wird gleich wie bei der ersten Variante vorgegangen, wobei zunächst ein nicht supraleitende Eigenschaften zeigender Sinterkörper hergestellt wird. Das Diagramm bedarf keiner weiteren Erklärungen.

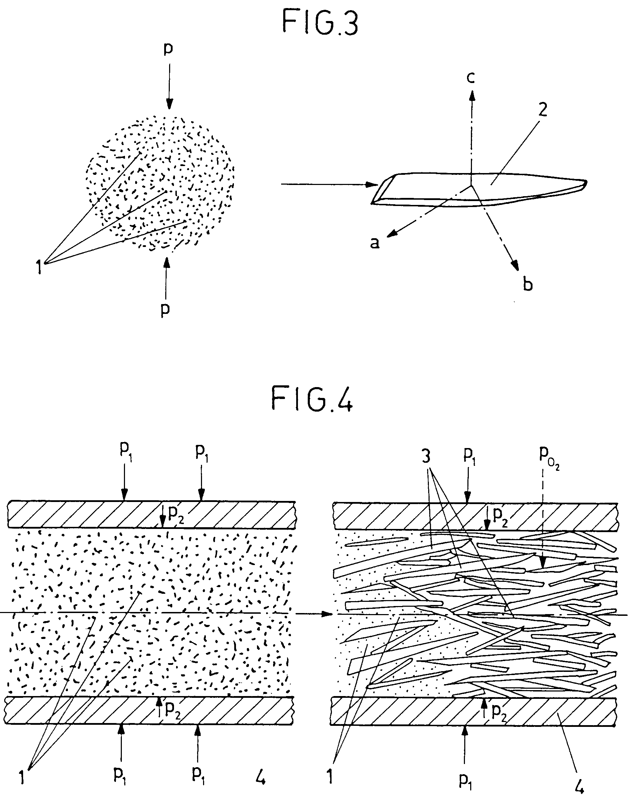

Fig. 3 zeigt eine schematische Darstellung der Ueberführung eines losen Pulvers aus supraleitender Substanz in einen Einkristall mittels Drucksintern. 1 ist das feinkörnige Pulver aus supraleitender Substanz, im vorliegenden Fall YBa₂Cu₃O_{≈7}, mit einer Partikelgrösse von ca. 2 µm. p stellt den äusserlich beim Drucksinterprozess anzuwendenden Druck dar. Grundsätzlich wird dabei ein nadelförmiger Einzelkristall (Einkristall) 2 aus supraleitender Substanz erzeugt, dessen kristallographische a/b-Ebene in der bevorzugten Längsrichtung liegt, während die c-Achse senkrecht zu dieser Längsrichtung steht. Die besten supraleitenden Eigenschaften des Materials werden in der a/b-Ebene gemessen, fallen somit mit der Längsachse des Einkristalls 2 zusammen.

In Fig. 4 ist ein schematischer Schnitt (vereinfachte metallographische Darstellung) durch einen länglichen Körper aus nadelförmigen orientierten Kristallen dargestellt. 1 ist das feinkörnige Pulver (Partikelgrösse ca. 2 µm) aus supraleitender Substanz, welche jedoch auch durch ein komplexes, noch nicht vollständig reagiertes Mischsalz (Zwischenprodukt aus Copräzipitation) ersetzt sein kann. 3 ist der Verband längsgerichteter nadelförmiger Einzelkristalle aus der supraleitenden Substanz (z.B. YBa₂Cu₃O_{≈7}). 4 ist ein als Träger und Hülle diendendes Silberröhrchen, das gleichzeitig die Funktion des Notstromleiters übernimmt. p ist der beim Drucksintern aufgewendete äussere Druck, p₂ der entsprechende, noch auf das feinkörnige Pulver 1 ausgeübte innere Druck. pO₂ stellt den beim Sintervorgang bzw. bei der nachfolgenden Wärmebehandlung aufzuwendende O₂-Partialdruck dar, der für die Ueberführung des Materials in die orthorhombische Phase mit der optimalen Supraleitereigenschaften aufzuwenden ist.

### Ausführungsbeispiel 1:

### Siehe Fig. 1 und Fig. 3!

Zunächst wurde ein Pulver 1 für die supraleitende Substanz YBa₂Cu₃O_{6,5+y} mit Y ≈ 0,45 hergestellt. Zu diesem Zweck wurden als Ausgangssubstanzen die Oxyde Y₂O₃; BaO und CuO benutzt. Stöchiometrische Mengen von Oxydpulvern mit dem Atomverhältnis Y:Ba:Cu = 1:2:3 wurden gemischt, gemahlen, gepresst und der Pressling bei einer Temperatur von 950 °C reaktiv gesintert. Dann wurde der Sinterkörper gemahlen, nochmals gepresst und erneut gesintert, um eine einzige homogene Phase zu erzeugen. Gegebenenfalls wird dieser Prozess (Sintern im Bereich von 930 bis 1000 °C) mehrmals wiederholt, um jegliche Anwesenheit einer nicht der obigen Stöchiometrie entsprechenden Fremdphase auszumerzen. Schliesslich wurde der fertig reagierte Sinterkörper zu einem feinkörnigen Pulver 1 mit einer mittleren Korngrösse von 2 µm vermahlen. Aus diesem Pulver 1 wurde ein Körper von 10 mm Durchmesser und 3 mm Höhe vorgepresst. Der Pressling wurde in einer geheizten Presse während 10 h bei einer Temperatur von 800 °C einem axialen Stempeldruck von 2000 bar ausgesetzt. Dieser Drucksinterprozess wurde einmal unter Vakuum, ein weiteres Mal unter Argon als Schutzgas durchgeführt. Als Variante wurde ausserdem ein entsprechender Versuch unter O₂-Atmosphäre von 1 bar Druck ausgeführt. Das Ergebnis war in jedem Fall ein Körper mit vergleichsweise groben, mit ihrer Längsachse quer zur Richtung des aussen aufgewendeten Druckes p orientierten länglichen, nadelförmigen Einzelkristallen 2 (siehe Fig. 3!). Nach dem Drucksinterprozess wurde der Körper während 5 h im Temperaturbereich von 400 bis 500 °C unter O₂-Atmosphäre geglüht, um die supraleitende Substanz mit der optimalen orthorhombischen Kristallstruktur entsprechend der Formel YBa₂Cu₃O_{≈7} zu erzeugen.
Nach Abkühlung auf 77 K wurde die kritische Stromdichte j_{c} mit 1200 A/cm² bestimmt.

### Ausführungsbeispiel 2:

### Siehe Fig. 2 und 4!

Es wurde ein Körper aus der supraleitenden Substanz YBa₂Cu₃O_{≈7} hergestellt. Das Pulver wurde nach der Copräzipitationsmethode hergestellt. Stöchiometrische Mengen von Y-, Ba- und Cu-Salzen wurden in Lösung gebracht und mit einem Fällungsmittel zu einem unlöslichen Gel umgesetzt, welches durch Trocknen und anschliessende Wärmebehandlungen in ein Pulver und schliesslich in einen Sinterkörper übergeführt wurde. Im vorliegenden Fall wurden die Nitrate der Y, Ba und Cu in H₂O gelöst und mit Na-Karbonat in Form eines komplexen Mischkarbonat-Hydroxyds ausgefällt. Nach mehrfachem Waschen, Dispergieren in Ultraschall, Trocknen und Austreiben des H₂O und eines Teils des CO₂ wurde das Pulver des auf diese Weise erhaltenen nicht supraleitenden Zwischenprodukts auf eine Korngrösse von durchschnittlich 2 um gemahlen und in ein Ag-Röhrchen 4 von 6 mm Aussendurchmesser und 0,6 mm Wandstärke eingefällt. Dann wurde das gefüllte Ag-Röhrchen 4 zu einem Draht von 0,5 mm Aussendurchmesser heruntergezogen und das Ganze in ähnlicher Weise wie Beispiel 1 wärmebehandelt. Die Enden des zu einem dünnen Draht ausgezogenen Ag-Röhrchens 4 wurden verschlossen, das ganze unter einen hydrostatischen Druck von 1000 bar gesetzt und bei einer Temperatur von 850 °C während 5 h geglüht. Anschliessend wurde gemäss Beispiel 1 eine Glühung unter O₂-Atmosphäre bei einer Temperatur von 500 °C während 5 h durchgeführt. Der dabei gebildete Verbundkörper bestand aus einem supraleitenden Kern aus einem Verband 3 nadelförmiger, gerichteter Kristalle der Substanz YBa₂Cu₃O_{≈7} und einer als Träger und Notstromleiter wirkenden Hülle 4 aus Ag.
Die kritische Stromdichte betrug 1100 A/cm².

### Ausführungsbeispiel 3:

Gemäss Beispiel 2 wurde ein Pulver eines komplexen Mischoxyds mit einem mittleren Partikeldurchmesser von ca. 2 µm hergestellt. Dieses Pulver wurde in ein Ag-Röhrchen 4 von 8 mm Aussendurchmesser und 0,8 mm Wandstärke abgefüllt und das Ganze auf einen Durchmesser von 0,6 mm heruntergezogen. 7 derartige Leiter wurden in ein Ag-Röhrchen von ca. 1,8 mm Innendurchmesser und 0,4 mm Wandstärke eingeführt und das Bündel auf einen Aussendurchmesser von 0,6 mm heruntergezogen. 7 derartige Bündel wurden erneut in ein entsprechendes Ag-Röhrchen eingeführt und das Ganze zu einem Multifilament-Leiter von ca. 0,8 mm Aussendurchmesser heruntergezogen. Nun wurde gemäss Beispiel 2 ein Drucksinterprozess bei 920 °C / 5 h durchgeführt und das Ganze anschliessend bei 500 °C / 5 h unter O₂-Atmosphäre geglüht.
Die kritische Stromdichte j_{c} wurde mit 1300 A/cm² bestimmt.

Die Erfindung ist nicht auf die Ausführungsbeispiele beschränkt.

Das Verfahren zur Herstellung eines länglichen Körpers bestehend aus längsgerichteten nadelförmigen Kristallen (3) aus einem supraleitenden keramischen Stoff auf der Basis von SEBa₂Cu₃O_{6,5+y}, wobei SE ein seltenes Erdmetall und O<y<1 bedeutet und die supraleitenden einzelnen Kristalle (2; 3) durch Sintern erzeugt werden, wird durchgeführt, indem supraleitendes Pulver (1) mit einem Partikeldurchmesser von 0,1 bis 5 µm unter Anwendung eines Druckes von 100 bis 5000 bar bei einer Temperatur im Bereich von 600 bis 920 °C während 1 bis 100 h gesintert wird. Vorzugsweise hat das supraleitende Pulver (1) einen Partikeldurchmesser von 0,5 bis 5 µm und der Druck beträgt 500 bis 2000 bar, wobei das Sintern bei einer Temperatur von höchstens 920 °C während 5 bis 20 h durchgeführt wird.

Gemäss einer Variante wird das Verfahren durchgeführt, indem beim Sintern ein Druck von 2000 bar und eine Temperatur von 800 °C während 10 h angewendet werden.

In vielen praktischen Fällen wird das supraleitende Pulver (1) mit einer mittleren Partikelgrösse von 2 µm in ein Silberröhrchen (4) abgefüllt und das Ganze zu einem Filamentleiter gezogen und unter einem äusseren Druck von 2000 bar bei einer Temperatur von 800 °C während 10 h zu einem aus einzelnen längsgerichteten nadelförmigen Kristallen (23) aufgebautem Supraleiterdraht gesintert.

## Patentansprüche

1. Verfahren zur Herstellung eines länglichen Körpers bestehend aus längsgerichteten, nadelförmigen Kristallen (2,3) aus einem keramischen Hochtemperatur-Supraleiter auf der Basis von SEBa₂Cu₃O_{6,5+y}, wobei SE ein seltenes Erdmetall bedeutet und 0<y<1 ist, bei welchem Verfahren
(a) ein homogenes, nicht-supraleitendes Vormaterial (1) in Pulverform hergestellt wird, welches die Elemente RE, Ba und Cu in einem stöchiometrischen Verhältnis von RE:Ba:Cu = 1:2:3 enthält;
(b) aus dem Vormaterial (1) der längliche Körper geformt wird; und
(c) der längliche Körper unter hohem Druck und hohen Temperaturen gesintert wird;
dadurch gekennzeichnet, dass
(d) das pulverförmige Vormaterial (1) einen mittleren Partikeldurchmesser von 0,5 bis 5 µm aufweist;
(e) die Sinterung unter einem Druck von 50 MPa (500 bar) bis 200 MPa (2000 bar) und bei einer Temperatur zwischen 600°C und 850°C für eine Zeit zwischen 5 und 20 h durchgeführt wird.

2. Verfahren nach Anspruch 1, dadurch gekennzeichnet, dass Y als das Element RE verwendet wird.

3. Verfahren nach Anspruch 2, dadurch gekennzeichnet, dass das nicht-supraleitende Vormaterial (1) durch Mischen von pulverförmigem Y₂O₃, BaO und CuO in besagtem stöchiometrischen Verhältnis und nachfolgendes mehrmaliges Sintern und Mahlen erzeugt wird.

4. Verfahren nach Anspruch 2, dadurch gekennzeichnet, dass das nicht-supraleitende Vormaterial (1) durch Kopräzipitation hergestellt wird.

5. Verfahren nach einem der Ansprüche 1 bis 4, dadurch gekennzeichnet, dass
(a) das pulverförmige Vormaterial (1) mit einem mittleren Partikeldurchmesser von 2 µm in ein Silberröhrchen (4) eingefüllt wird;
(b) das gefüllte und verschlossene Silberröhrchen (4) zu einem Filamentleiter heruntergezogen wird; und
(c) der Filamentleiter unter einem äusseren Druck von etwa 200 MPa (2000 bar) bei einer Temperatur von etwa 800°C für etwa 10 h gesintert wird.

6. Verfahren nach einem der Ansprüche 1 bis 5, dadurch gekennzeichnet, dass
(a) die Drucksinterung im Vakuum oder unter einem Schutzgas durchgeführt wird; und
(b) der längliche Körper nach der Drucksinterung in einer O₂-Atmosphäre bei einer Temperatur zwischen 400 und 500°C während etwa 5 h geglüht wird.

## Claims

1. Process for the production of an elongate body consisting of longitudinally aligned acicular crystals (2, 3) of a ceramic high-temperature superconductor based on SEBa₂Cu₃O_{6,5+y}, where SE means a rare earth metal and 0<y<1, in which process
(a) a homogeneous, non-superconducting starting material (1) is produced in pulvervlent form and contains the elements RE, Ba and Cu in a stoichiometric ratio of RE:Ba:Cu = 1:2:3;
(b) the elongate body is formed from the starting material (1); and
(c) the elongate body is sintered under high pressure and at high temperatures;
characterized in that
(d) the pulverulent starting material (1) has an average particle diameter of 0.5 to 5 µm;
(e) the sintering is carried out under a pressure of 50 MPa (500 bar) to 200 MPa (2000 bar) and at a temperature between 600°C and 850°C for a period between 5 and 20 h.

2. Process according to Claim 1, characterized in that Y is used as the element RE.

3. Process according to Claim 2, characterized in that the non-superconducting starting material (1) is produced by mixing pulverulent Y₂O₃, BaO and CuO in the said stoichiometric ratio and by subsequent repeated sintering and milling.

4. Process according to Claim 2, characterized in that the non-superconducting starting material (1) is produced by coprecipitation.

5. Process according to one of Claims 1 to 4, characterized in that
(a) the pulverulent starting material (1) with an average particle diameter of 2 µm is filled into a small silver tube (4);
(b) the filled and sealed small silver tube (4) is drawn down to a filament conductor; and
(c) the filament conductor is sintered for approximately 10 h at a temperature of approximately 800°C under an external pressure of approximately 200 MPa (2000 bar).

6. Process according to one of Claims 1 to 5, characterized in that
(a) the pressure sintering is carried out in vacuum or in a protective gas; and
(b) after the pressure sintering the elongate body is annealed for approximately 5 h in an O₂ atmosphere at a temperature between 400 and 500°C.

## Revendications

1. Procédé de préparation d'un corps oblong consistant en cristaux de direction longitudinale sous forme d'aiguilles (2, 3) en supraconducteur hautes températures céramique à base de TRBa₂Cu₃O_{6,5+y}, TR signifiant une terre rare et 0 < y < 1, procédé pour lequel
(a) on prépare un matériau précurseur homogène, non supraconducteur (1) sous forme de poudre, qui contient les éléments RE, Ba, et Cu dans un rapport stoechiométrique de RE:Ba:Cu = 1:2:3;
(b) on forme à partir du matériau précurseur (1) le corps oblong; et
(c) on fritte le corps oblong à haute pression et à hautes températures;
caractérisé en ce que
(d) le matériau précurseur (1) sous forme de poudre présente un diamètre de particules moyen de 0,5 à 5 µm;
(e) le frittage est effectué sous une pression de 50 MPa (500 bar) à 200 MPa (2000 bar) et à une température entre 600 et 850°C pendant une durée entre 5 et 20 heures.

2. Procédé selon la revendication 1, caractérisé en ce que l'on utilise Y en tant qu'élément RE.

3. Procédé selon la revendication 2, caractérisé en ce que l'on produit le matériau précurseur non conducteur (1) par mélange de Y₂O₃, de BaO et de CuO sous forme de poudres dans ledit rapport stoechiométrique et par frittage et mouture consécutifs répétés.

4. Procédé selon la revendication 2, caractérisé en ce que l'on prépare le matériau précurseur non conducteur (1) par coprécipitation.

5. Procédé selon l'une quelconque des revendications 1 à 4, caractérisé en ce que
(a) l'on remplit le matériau précurseur sous forme de poudre (1) ayant un diamètre de particules moyen de 2 µm dans un tube en argent (4);
(b) on étire le tube en argent rempli et scellé (4) en un conducteur sous forme de filament; et
(c) on fritte le conducteur sous forme de filament sous une pression externe d'environ 200 MPa (2000 bar) à une température d'environ 800°C pendant environ 10 heures.

6. Procédé selon l'une quelconque des revendications 1 à 5, caractérisé en ce que
(a) l'on effectue le frittage sous pression sous vide ou sous un gas de protection; et
(b) on procède à la cuisson du corps oblong après le frittage sous pression ou sous une atmosphère d'O₂ à une température entre 400 et 500°C pendant environ 5 heures.
